# EUROPEAN PATENT APPLICATION

(11) **EP 4 317 998 A1**
(43) Date of publication of application: **07.02.2024**
(21) Application number: 22781339.1
(22) Date of filing: 04.04.2022
(51) Int. Cl.: G01R 29/08

(54) **MICROWAVE LEAK DETECTION METHOD AND MICROWAVE LEAK DETECTION DEVICE**

(30) Priority: 02.04.2021 JP 2021063631
(71) Applicant: Microwave Chemical Co., Ltd., Osaka-shi, Osaka 559-0025 (JP)
(72) Inventor: HORI, Naoki, Osaka-shi, Osaka 559-0025 (JP)
(74) Representative: Betten & Resch
(86) International application number: PCT/JP2022/017025
(87) International publication number: WO 2022/211132

(57) **Abstract**

The present invention provides a microwave leakage detection device for use in an explosion-proof area. A microwave leakage detection device 1 includes an explosion-proof sensor 10a with an explosion-proof structure capable of detecting an increase in at least one of an electric field and a magnetic field, and a detection unit 20 configured to detect a microwave leakage in accordance with detection of an increase in at least one of an electric field and a magnetic field by the explosion-proof sensor 10a. The explosion-proof sensor 10 is an inductive explosion-proof proximity sensor, and includes a detection coil 11 and an internal circuit 12.

## Description

### Technical Field

The present invention relates to a leakage detection method and a leakage detection device that detect a microwave leakage, as well as a sensor device used therein.

### Background Art

In processes that use flammable gas, vapor, powder dust or the like, typically, an area in which electronic devices can be used is defined as an explosion-proof area. This is because there is a risk that an electronic device becomes an ignition source and causes an explosion. Therefore, in such an explosion-proof area, electronic devices are used that have an explosion-proof structure so as not to become an ignition source.

### Summary of Invention

### Technical Problem

A microwave irradiation process may be performed within an explosion-proof area. In such a case, there is a demand for detecting a microwave leakage, but sensors with an explosion-proof structure capable of detecting a microwave leakage are not widely available, causing a problem that it is difficult to detect a microwave leakage while microwave irradiation is performed within an explosion-proof area.

The present invention was made in view of the above-described problem, and it is an object thereof to provide a microwave leakage detection method and a microwave leakage detection device that are for detecting a microwave leakage while microwave irradiation is performed within an explosion-proof area, as well as a sensor device used therein.

### Solution to Problem

In order to achieve the above-mentioned object, a microwave leakage detection method according to one aspect of the present invention includes: a step of arranging, in an explosion-proof area, one or more sensors with an explosion-proof structure capable of detecting an increase in at least one of an electric field and a magnetic field, at a place at which a microwave leakage is desired to be detected; and a step of detecting a microwave leakage in accordance with detection of an increase in at least one of an electric field and a magnetic field by at least one of the one or more sensors.

Also, in the microwave leakage detection method according to one aspect of the present invention, each of the one or more sensors may be an inductive or capacitive explosion-proof proximity sensor, and in the step of detecting a microwave leakage, a microwave leakage may be detected when an output from at least one of the one or more sensors is equal to an output that corresponds to object detection.

Also, in the microwave leakage detection method according to one aspect of the present invention, in the sensor arranging step, one or more sensors may be arranged at a joint portion of flanges of hollow members each having a space into which microwaves are introduced, and in the microwave leakage detecting step, detection of a microwave leakage may be performed while microwaves are introduced into the spaces.

Also, in the microwave leakage detection method according to one aspect of the present invention, in the sensor arranging step, one or more sensors may be arranged on the outer side of a choke structure for preventing microwaves from leaking from inside to outside of a container in which microwave irradiation is performed, and in the microwave leakage detecting step, detection of a microwave leakage may be performed while microwave irradiation is performed in the container.

Also, in the leakage detection method according to one aspect of the present invention, the one or more sensors are directional, and in the sensor arranging step, one or more sensors may be arranged so as to be able to detect microwaves in a direction in which microwaves leak.

A microwave leakage detection device according to one aspect of the present invention includes: a sensor with an explosion-proof structure capable of detecting an increase in at least one of an electric field and a magnetic field; and a detection unit configured to detect a microwave leakage in accordance with detection of an increase in at least one of an electric field and a magnetic field by the sensor.

Also, in the microwave leakage detection device according to one aspect of the present invention, the sensor may be an inductive or capacitive explosion-proof proximity sensor.

A sensor device for detecting a microwave leakage according to one aspect of the present invention includes: an inductive or capacitive explosion-proof proximity sensor with an explosion-proof structure; and a protective member that is provided so as to surround an object detection range of the explosion-proof proximity sensor, and through which microwaves are transmitted.

A sensor device for detecting a microwave leakage according to one aspect of the present invention includes: a sensor with an explosion-proof structure capable of detecting an increase in at least one of an electric field and a magnetic field; and a reflective member provided around the sensor and configured to guide microwaves to the sensor.

Also, in the sensor device according to one aspect of the present invention, the sensor may be an inductive or capacitive explosion-proof proximity sensor.

### Advantageous Effects of Invention

With the microwave leakage detection method and the microwave leakage detection device according to the present invention, by arranging, in an explosion-proof area, a sensor with an explosion-proof structure capable of detecting an increase in at least one of an electric field and a magnetic field, at a place at which a microwave leakage is desired to be detected, it is possible to detect a microwave leakage while microwave irradiation is performed within the explosion-proof area.

### Brief Description of Drawings

FIG. 1 is a diagram schematically illustrating a configuration of a microwave leakage detection device according to an embodiment of the present invention.
FIG. 2A is a diagram illustrating an experiment using an explosion-proof sensor according to the embodiment.
FIG. 2B is a diagram illustrating an experiment using the explosion-proof sensor according to the embodiment.
FIG. 3A is a diagram schematically illustrating another configuration of the microwave leakage detection device according to the embodiment.
FIG. 3B is a diagram schematically illustrating the other configuration of the microwave leakage detection device according to the embodiment.
FIG. 4 is a diagram schematically illustrating yet another configuration of the microwave leakage detection device according to the embodiment.
FIG. 5 is a diagram illustrating a sensor device including a protective member according to the embodiment.
FIG. 6A is a diagram illustrating the sensor device including a reflective member according to the embodiment.
FIG. 6B is a diagram illustrating the sensor device including a reflective member according to the embodiment.
FIG. 6C is a diagram illustrating the sensor device including a protective member and the reflective member according to the embodiment.
FIG. 7A is a diagram illustrating the sensor device including a reflective member according to the embodiment.
FIG. 7B is a cross-sectional view illustrating the sensor device including the reflective member according to the embodiment.
FIG. 8A is a diagram illustrating a layout of explosion-proof sensors according to the embodiment.
FIG. 8B is a diagram illustrating the layout of the explosion-proof sensors according to the embodiment.
FIG. 8C is a diagram illustrating a layout of the explosion-proof sensors according to the embodiment.
FIG. 9 is a diagram illustrating a layout of the explosion-proof sensors according to the embodiment.
FIG. 10 is a diagram illustrating a layout of the explosion-proof sensors according to the embodiment.
FIG. 11A is a diagram illustrating a layout of an explosion-proof sensor according to the embodiment.
FIG. 11B is a diagram illustrating the layout of the explosion-proof sensor according to the embodiment.

### Description of Embodiment

The following describes a microwave leakage detection method and a microwave leakage detection device according to an aspect of the present invention, as well as a sensor device used therein, with reference to an embodiment. Note that in the following embodiment, the constituent elements denoted by the same reference numerals are the same or similar to each other, and thus redundant descriptions may be omitted. The microwave leakage detection method and the microwave leakage detection device according to the present embodiment are configured to detect a microwave leakage using a sensor with an explosion-proof structure. Also, the sensor device according to the present embodiment is a device for use in detecting a microwave leakage.

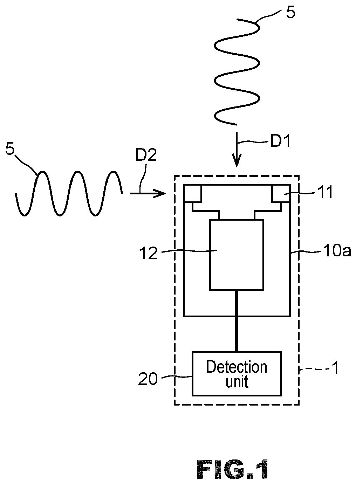

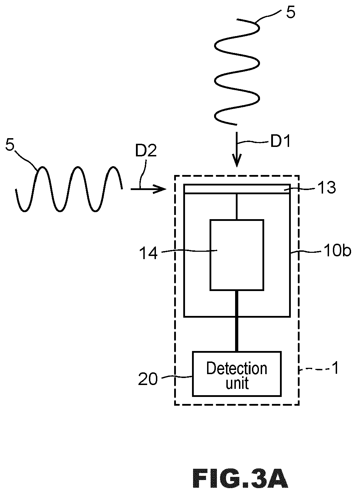

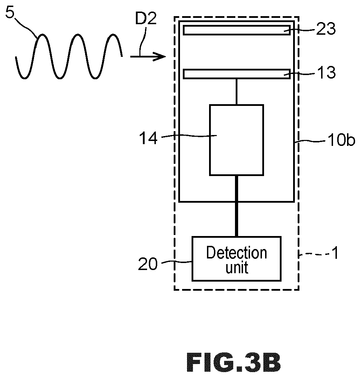

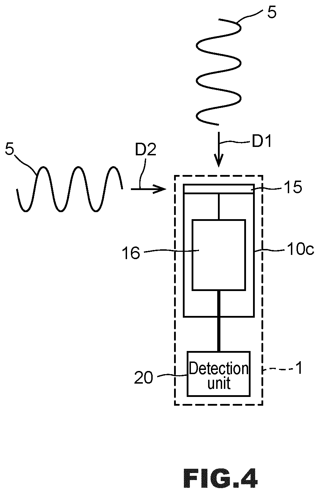

FIGS. 1, 3A, 3B, and 4 are diagrams schematically illustrating configurations of a microwave leakage detection device 1 according to the embodiment. The microwave leakage detection device 1 includes an explosion-proof sensor 10 with an explosion-proof structure capable of detecting an increase in at least one of an electric field and a magnetic field, and a detection unit 20 that detects a microwave leakage in accordance with detection of an increase in at least one of an electric field and a magnetic field by the explosion-proof sensor 10. Note that FIG. 1 shows an explosion-proof sensor 10a, which is an inductive explosion-proof proximity sensor, FIGS. 3A and 3B show an explosion-proof sensor 10b, which is a capacitive explosion-proof proximity sensor, and FIG. 4 shows an explosion-proof sensor 10c, which is a magnetic explosion-proof proximity sensor. The explosion-proof sensors 10a, 10b and 10c, if not particularly distinguished, are referred to as the explosion-proof sensor 10 as described above. Examples of the explosion-proof sensor 10 may include a sensor with a pressure-tight explosion-proof structure, a sensor with an internal pressure explosion-proof structure, a sensor with an increased safety explosion-proof structure, a sensor with an oil-filled explosion-proof structure, or a sensor with an intrinsic safety explosion-proof structure. As the type of structure such as the pressure-tight explosion-proof structure or internal pressure explosion-proof structure, a type of structure appropriate for the type of explosion-proof area is preferably selected.

In FIG. 1, the explosion-proof sensor 10a, which is an inductive explosion-proof proximity sensor, includes a detection coil 11 and an internal circuit 12. When the explosion-proof sensor 10a is used as a proximity sensor, the internal circuit 12 causes the detection coil 11 to generate a high-frequency magnetic field. Then, if a metal object approaches the explosion-proof sensor 10a, an inductive current (eddy current) will flow through the metal object, and the impedance of the detection coil 11 will be changed. The internal circuit 12 can detect the object based on the change in the impedance. On the other hand, as shown in FIG. 1, also when the detection coil 11 is irradiated with microwaves 5, a high-frequency magnetic field is disturbed and the impedance of the detection coil 11 is changed, and thus the internal circuit 12 can detect microwaves in the same manner as in the case of object detection. That is to say, the detection unit 20 may detect a microwave leakage when the output from the explosion-proof sensor 10a is equal to an output that corresponds to object detection. Note that when the output from the explosion-proof sensor 10a is equal to an output that corresponds to object detection, the intensity of an electromagnetic field of microwaves at a position of the detection coil 11 exceeds a predetermined value. Accordingly, the explosion-proof sensor 10a can be regarded as a sensor capable of detecting an increase in at least one of an electric field and a magnetic field.

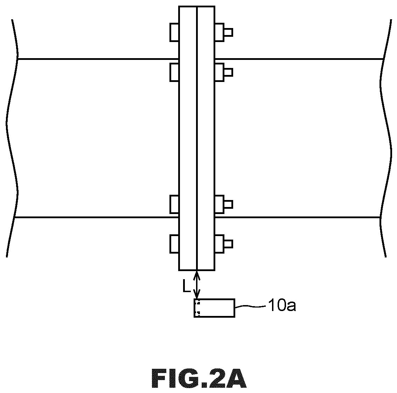

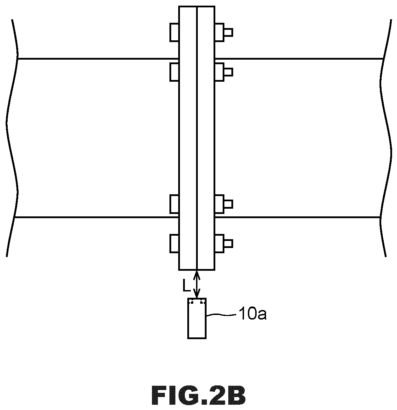

A microwave detection experiment was conducted using an inductive explosion-proof proximity sensor. In the experiment, as shown in FIG. 2A, the explosion-proof sensor 10a is disposed at a distance L from a joint portion of flanges of waveguides, and microwaves leaking from the joint portion of the flanges of the waveguides were detected. In FIG. 2A, the detection coil 11 indicated by a dotted line is located on the left side of the explosion-proof sensor 10a. In the experiment, microwaves were detected in a state in which the microwave leakage level is 3 (mW/cm²) at the distance L in FIG. 2 of 5 cm. The microwave leakage level was measured using a high-frequency electromagnetic field measuring instrument manufactured by Narda (indicator: NBM-520, probe: E0391). Also, as the explosion-proof sensor 10a, three types of explosion-proof structure proximity sensors manufactured by IDEC Corporation were used, the explosion-proof structure proximity sensors respectively having detection distances of 5 mm, 10 mm, and 15 mm. The results of the experiment are as follows:

**[Table 1]**

| Explosion-proof proximity sensor (type) | Detection distance (mm) | Distance L (cm) | Electromagnetic field intensity at the detection distance (mW/cm²) |
|---|---|---|---|
| Ni5-G12-Y1X | 5 | - | - |
| Ni10-G18-Y1X | 10 | 1 | 75.00 |
| Ni15-G30-Y1X | 15 | 3 | 8.33 |

The proximity sensor with the detection distance of 5 mm could not detect any microwave, whereas the proximity sensors with the detection distances of 10 mm and 15 mm could detect microwaves at the distances L of 1 cm and 3 cm, respectively. The electromagnetic field intensities at these distances are as given in the above-described table. Also, when the explosion-proof sensor 10a was disposed as shown in FIG. 2B, no microwave could be detected. Thus, the explosion-proof sensor 10a used in the experiment could not detect any microwave 5 in the direction of the arrow D 1 in FIG. 1, but could detect microwaves 5 in the direction of the arrow D2. Accordingly, the explosion-proof sensor 10a, which is an inductive explosion-proof proximity sensor, is directional. Also, it was found that the larger the detection distance of the explosion-proof proximity sensor is, the higher microwave detection sensitivity it has, so that weaker microwaves can also be detected. Accordingly, it is sufficient to use an explosion-proof proximity sensor with a detection distance that corresponds to the intensity of microwaves desired to be detected. Note that the detection distance of a proximity sensor means a distance at which the proximity sensor is turned on when a standard detection object is brought close to the proximity sensor in a direction perpendicular to the detection surface thereof.

In FIG. 3A, the explosion-proof sensor 10b, which is a capacitive explosion-proof proximity sensor, includes an electrode 13 and an internal circuit 14. When the explosion-proof sensor 10b is used as a proximity sensor, the internal circuit 14 includes, for example, a high-frequency oscillation circuit, and if an object such as a dielectric substance approaches the explosion-proof sensor 10b, the charge of the electrode 13 will change, and the internal circuit 14 can detect the object based on an oscillated state of the oscillation circuit changed in accordance with the change in the charge of the electrode 13. On the other hand, as shown in FIG. 3A, also when the electrode 13 is irradiated with microwaves, the charge of the electrode 13 will change and thus the internal circuit 14 can detect the microwaves in the same manner as in the case of object detection. That is to say, the detection unit 20 may detect a microwave leakage when the output from the explosion-proof sensor 10b is equal to an output that corresponds to object detection. Note that when the output from the explosion-proof sensor 10b is equal to an output that corresponds to object detection, the intensity of an electric field of microwaves at a position of the electrode 13 exceeds a predetermined value. Accordingly, the explosion-proof sensor 10b can be regarded as a sensor capable of detecting an increase in at least one of an electric field and a magnetic field.

In the capacitive explosion-proof sensor 10b, the microwaves 5 in the direction of the arrow D1 in FIG. 3A can change the charge of the electrode 13 more significantly than the microwaves 5 in the direction of the arrow D2. Accordingly, the explosion-proof sensor 10b can more easily detect the microwaves 5 in the direction of the arrow D 1 than the microwaves 5 in the direction of the arrow D2, and is thus directional.

In a microwave detection experiment conducted using a capacitive explosion-proof proximity sensor, the configuration in which, as shown in FIG. 3B, a metal plate 23 was disposed so as to face the electrode 13 had a higher sensitivity of microwave detection and could detect weaker microwaves, compared to the configuration shown in FIG. 3A. The metal plate 23 is typically a flat plate, and the size thereof is preferably the same as or greater than the electrode 13. In this case, as shown in FIG. 3B, the explosion-proof sensor 10b may include the electrode 13, the internal circuit 14, and the metal plate 23 disposed so as to face the electrode 13. The metal plate 23 is disposed on a side of the electrode 13 on which the proximity sensor performs object detection. In the explosion-proof sensor 10b shown in FIG. 3B, microwaves moving in a normal direction with respect to the plane of the electrode 13 or the metal plate 23 are shielded by the metal plate 23 and do not reach the electrode 13, and thus the microwaves 5 in the direction of the arrow D2 are detected. Accordingly, the explosion-proof sensor 10b shown in FIG. 3B is also directional.

In FIG. 4, the explosion-proof sensor 10c, which is a magnetic explosion-proof proximity sensor, includes a hall IC 15 and an internal circuit 16. When the explosion-proof sensor 10c is used as a proximity sensor, if an object (such as, e.g., permanent magnet) that generates a magnetic field approaches the explosion-proof sensor 10c, a hall voltage is generated at the hall IC 15 due to the magnetic field. By amplifying and detecting the hall voltage, the internal circuit 16 can detect the object. On the other hand, as shown in FIG. 4, also when the hall IC 15 is irradiated with microwaves 5, a hall voltage is generated at the hall IC 15 due to the magnetic field of the microwaves 5, and thus the internal circuit 16 can detect the microwaves 5 in the same manner as in the case of object detection. That is to say, the detection unit 20 may detect a microwave leakage when the output from the explosion-proof sensor 10c is equal to an output that corresponds to object detection. Note that when the output from the explosion-proof sensor 10c is equal to an output that corresponds to object detection, the intensity of a magnetic field of microwaves at a position of the hall IC 15 exceeds a predetermined value. Accordingly, the explosion-proof sensor 10c can be regarded as a sensor capable of detecting an increase in at least one of an electric field and a magnetic field.

Although a case where the explosion-proof sensor 10c is an explosion-proof sensor provided with the hall IC 15, which is a hall element, has been described here, the explosion-proof sensor 10c may be an explosion-proof proximity sensor provided with a magnetic resistive element, instead of the hall IC 15. In this case, microwaves may be detected in accordance with an increase in resistance of the magnetic resistive element. Note that since the hall IC 15 detects a unidirectional magnetic field, the explosion-proof sensor 10c using the hall IC 15 is directional. On the other hand, since a magnetic resistive element detects an increase in magnetic field at a detection position, the explosion-proof sensor 10c using the magnetic resistive element is not directional, and can detect both the microwaves 5 in the direction of the arrow D1 and the microwaves 5 in the direction of the arrow D2. Also, even in the case of the explosion-proof sensor 10c using the hall IC 15, the explosion-proof sensor 10c can be made nondirectional if such an explosion-proof sensor 10c is configured to be able to cover multiple detection directions, for example, by using multiple hall ICs 15.

Note that the explosion-proof sensors 10a, 10b, and 10c, which are respectively inductive, capacitive, and magnetic explosion-proof proximity sensors, are commercially available, and thus detailed descriptions thereof are omitted. Also, the frequency of microwaves to be detected by the explosion-proof sensor 10 may be around, for example, 915 MHz, 2.45 GHz, 5.8 GHz, or 24 GHz, or may be in a range from 300 MHz to 300 GHz.

The explosion-proof sensor 10 with an explosion-proof structure capable of detecting an increase in at least one of an electric field and a magnetic field may be a sensor whose output changes when the intensity of microwaves at a sensing position exceeds a threshold. If the threshold can be adjusted, calibration of the threshold may be performed before arranging the explosion-proof sensor 10, so that a leakage of microwaves of a desired intensity can be detected. On the other hand, when the explosion-proof sensor 10, which is a commercially-available explosion-proof proximity sensor, is used, it is difficult to perform such calibration. In this case, the distance between a position at which microwaves leak, and the explosion-proof sensor 10 may be adjusted so that it is possible to detect a leakage of microwaves of a desired intensity. For example, when microwaves leaking from a joint portion of flanges of waveguides are to be detected, the explosion-proof sensor 10 can be disposed at a position closer to the joint portion to detect a leakage of weaker microwaves, and the explosion-proof sensor 10 can be disposed at a position far away from the joint portion to detect a leakage of microwaves having a higher intensity.

The detection unit 20 detects a microwave leakage in accordance with detection of an increase in at least one of an electric field and a magnetic field by the explosion-proof sensor 10. Note that when the explosion-proof sensor 10 is an explosion-proof proximity sensor, the detection unit 20 may detect a microwave leakage when the output from the explosion-proof sensor 10 is equal to an output that corresponds to object detection. Detecting a microwave leakage using the detection unit 20 may be, for example, outputting a detection result thereof using a predetermined method, or may be performing processing such as predetermined control upon detection of a leakage of microwaves. The output of a detection result may be, for example, display, sound output, transmission of the detection result, or the like. Also, when processing such as control is to be performed, the detection unit 20 may perform, upon detection of a microwave leakage, control of stopping a microwave generator from generating microwaves to disable microwave irradiation, for example. Note that the explosion-proof sensor 10 is typically disposed in an explosion-proof area. On the other hand, the detection unit 20 is typically disposed outside the explosion-proof area. When the detection unit 20 is disposed outside the explosion-proof area in this way, the detection unit 20 does not need to have an explosion-proof structure. Also, FIGS. 1, 3A, 3B, and 4 show cases where one explosion-proof sensor 10 is connected to the detection unit 20, but needless to say, two or more explosion-proof sensors 10 may also be connected to the detection unit 20. Accordingly, the microwave leakage detection device 1 may also include two or more explosion-proof sensors 10. When two or more explosion-proof sensors 10 are connected to the detection unit 20, the detection unit 20 may detect a microwave leakage in accordance with detection of an increase in at least one of an electric field and a magnetic field using at least one of the two or more explosion-proof sensors 10.

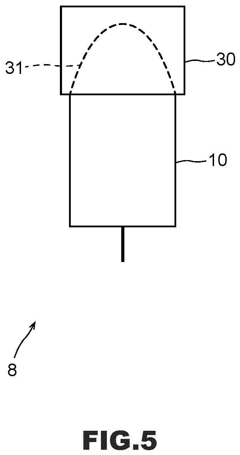

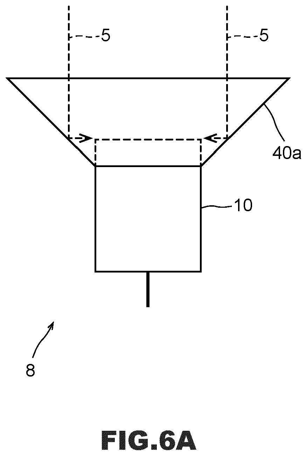

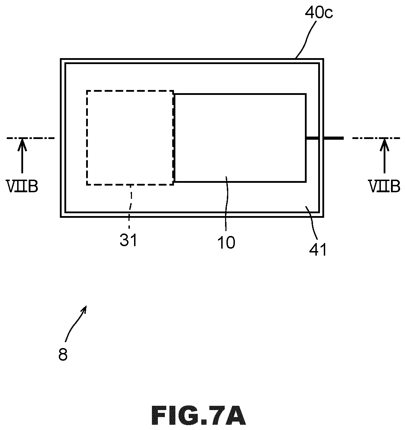

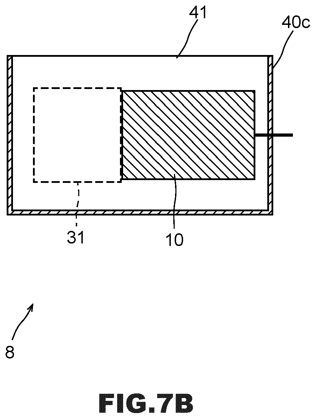

The following describes a sensor device 8 according to the present embodiment. FIG. 5 is a diagram showing a sensor device 8 including a protective member 30 provided in an object detection range 31 of the explosion-proof sensor 10, and FIGS. 6A to 6C, 7A, and 7B are diagrams each showing a sensor device 8 including a reflective member 40 for guiding microwaves to the explosion-proof sensor 10. In the microwave leakage detection device 1, the sensor device 8 may be used instead of the explosion-proof sensor 10.

In FIG. 5, the sensor device 8 includes the explosion-proof sensor 10 and the protective member 30. The explosion-proof sensor 10 may be, for example, the above-described explosion-proof proximity sensor. The protective member 30 is provided so as to surround the object detection range 31 of the explosion-proof sensor 10. The protective member 30 is used to prevent an object from entering the object detection range 31. Therefore, the protective member 30 is preferably provided so as to surround the entirety of the object detection range 31. Also, when the protective member 30 is made of a material detectable by the explosion-proof sensor 10, the protective member 30 is preferably not present within the object detection range 31 so that the explosion-proof sensor 10 does not detect the protective member 30. On the other hand, when the protective member 30 is made of a material undetectable by the explosion-proof sensor 10, the protective member 30 may be present within the object detection range 31. The expression that the protective member 30 is provided so as to surround the object detection range 31 of the explosion-proof sensor 10 is the concept including the case where the protective member 30 made of a material undetectable by the explosion-proof sensor 10 is present within the object detection range 31. As a result of the protective member 30 being provided, microwaves, instead of an object approaching the explosion-proof sensor 10, are detected by the explosion-proof sensor 10. Also, the protective member 30 is preferably made of a material through which microwaves are transmitted, so that the microwaves can be detected by the explosion-proof sensor 10. The material through which microwaves are transmitted is a material having a small dielectric loss, and may be, without being particularly limited to, a fluorine resin such as polytetrafluoroethylene, quartz, glass, ceramic, plastic, or the like, for example. The dielectric loss of a microwave transmissive material at a frequency of detection target microwaves and at a temperature at which a leakage is detected is preferably less than 1, more preferable less than 0.1, and furthermore preferably less than 0.01.

In FIG. 6A, the sensor device 8 includes the explosion-proof sensor 10 and a reflective member 40a for guiding microwaves 5 to the explosion-proof sensor 10. The reflective member 40a is provided around the explosion-proof sensor 10, and may be horn-shaped, as shown in FIG. 6A.

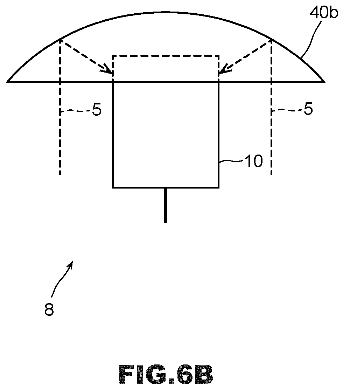

In FIG. 6B, the sensor device 8 includes the explosion-proof sensor 10 and a reflective member 40b for guiding microwaves 5 to the explosion-proof sensor 10. The reflective member 40b is provided around the explosion-proof sensor 10, and may be parabola-shaped, as shown in FIG. 6B. Note that the reflective members 40a and 40b, if not particularly distinguished, are referred to as the reflective member 40 as described above. The same applies to other reflective members.

The reflective member 40 may be made of, for example, a microwave reflective material. The microwave reflective material may be, for example, a metal. The metal may be, without being particularly limited to, stainless steel, carbon steel, aluminum, an aluminum alloy, nickel, a nickel alloy, copper, a copper alloy, or the like, for example.

Accordingly, by using the reflective member 40, it is possible to reflect and guide microwaves 5 to the directional explosion-proof sensor 10 such as an inductive explosion-proof proximity sensor, so that the explosion-proof sensor 10 can also detect microwaves in a direction different from that defined by the directionality of the sensor.

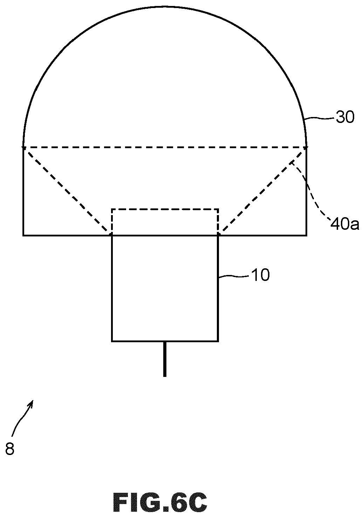

In FIG. 6C, the sensor device 8 includes the explosion-proof sensor 10, the protective member 30, and the reflective member 40a. In this way, the sensor device 8 may include both the protective member 30 and the reflective member 40.

FIGS. 7A and 7B are diagrams showing a sensor device 8 including a reflective member 40c in a cuboidal shape with an opening on one side, and the explosion-proof sensor 10 disposed inside the reflective member 40c. FIG. 7A shows the sensor device 8 when viewed from an opening 41 side, and FIG. 7B is a cross-sectional view taken along a line VIIB-VIIB in FIG. 7A. In FIG. 7B, the inner structure of the explosion-proof sensor 10 is omitted. The reflective member 40c may also be made of the above-described microwave reflective material. The explosion-proof sensor 10 is preferably disposed inside the reflective member 40c in such a manner that the reflective member 40c is not present in the object detection range 31. In the sensor device 8, microwaves introduced from the opening 41 are reflected on the inner surface of the reflective member 40c, and are detected by the explosion-proof sensor 10.

The following describes a microwave leakage detection method using the microwave leakage detection device 1. The microwave leakage detection method includes a step of arranging, in an explosion-proof area, one or more explosion-proof sensors 10 at a place at which microwave leakage is desired to be detected, and a step of detecting a microwave leakage in accordance with detection of an increase in at least one of an electric field and a magnetic field by at least one of the one or more explosion-proof sensors 10.

First, in the step of arranging the explosion-proof sensor 10, in the explosion-proof area, one or more explosion-proof sensors 10 are arranged at a place at which a microwave leakage is desired to be detected. If the explosion-proof sensor 10 is directional, one or more explosion-proof sensors 10 are preferably arranged so as to be able to detect microwaves in a direction in which microwaves leak.

The place at which a microwave leakage is desired to be detected may be, for example, a joint portion of flanges of hollow members each having a space into which microwaves are introduced. This is because, if joining at the joint portion of the flanges is not appropriate, microwaves may leak from the joint portion. The hollow member with a space into which microwaves are introduced may be, for example, a waveguide, a container inside of which microwave irradiation is performed, a connection tube to be connected to this container, or another type of hollow member with a space into which microwaves are introduced. The connection tube may be, for example, a connection tube such as a viewing window, an injection opening for a row material or the like, a discharge opening for a product or the like, a cleaning line, an inlet, or an outlet.

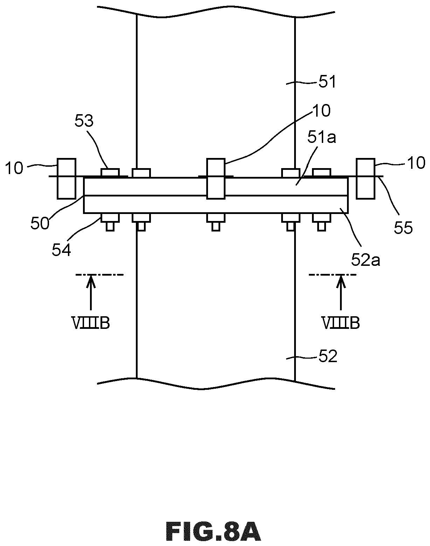

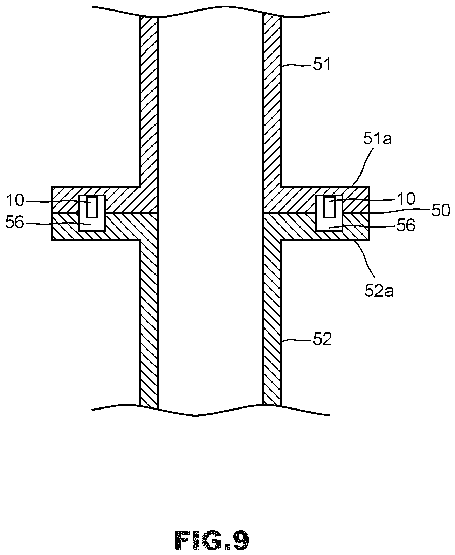

In this case, one or more explosion-proof sensors 10 may be arranged at the joint portion of the flanges of the hollow members each having a space into which microwaves are introduced. Arranging the explosion-proof sensors 10 at the joint portion of the flanges may mean arranging the explosion-proof sensors 10 around the joint portion of the flanges, or arranging the explosion-proof sensors 10 in a hollow portion provided in the joint portion of the flanges. Here, the former case will be described with reference to FIGS. 8A to 8C, and the latter case will be described with reference to FIG. 9.

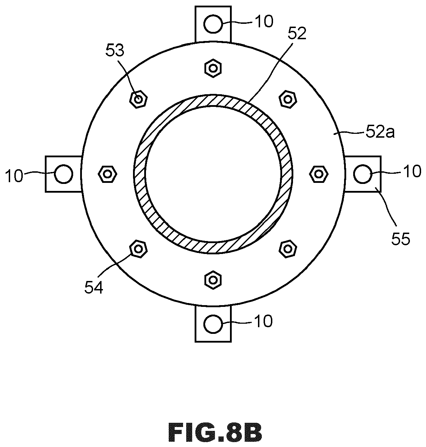

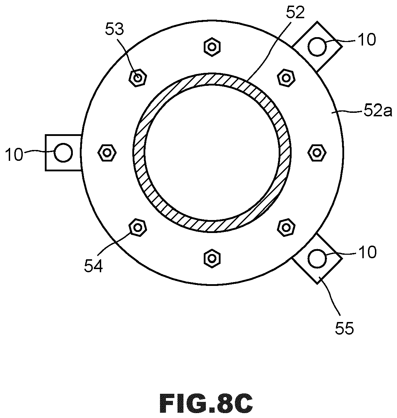

FIGS. 8A and 8B are diagrams showing an example in which four explosion-proof sensors 10 are arranged around a joint portion 50 of flanges 51a and 52a of waveguides 51 and 52. FIG. 8A is a diagram showing the waveguides 51 and 52 when viewed in a direction perpendicular to the central axis of the waveguides 51 and 52, and FIG. 8B is a cross-sectional view taken along the line VIIIB-VIIIB in FIG. 8A. As shown in FIGS. 8A and 8B, the flange 51a of the circular waveguide 51 and the flange 52a of the circular waveguide 52 are connected to each other via bolts 53 and nuts 54. Also, four attachments 55 are fixed to the flange 51a using some of the bolts 53, and the explosion-proof sensors 10 are fixed to the respective attachments 55. Microwaves leaking from the joint portion 50 of the flanges 51a and 52a are considered to move in a direction along the joint surface. Accordingly, if the explosion-proof sensors 10 are inductive explosion-proof proximity sensors, the explosion-proof sensors 10 are directional, and thus are preferably arranged as shown in FIGS. 8A and 8B. That is to say, the explosion-proof sensors 10 are preferably arranged such that the direction of a microwave leakage conforms to the direction indicated by the arrow D2 in FIG. 1. Also, as shown in FIG. 8B, the four explosion-proof sensors 10 are preferably arranged at a uniform angle, that is, at every 90 degrees to the central axis of the waveguides 51 and 52 in the longitudinal direction. Therefore, if three explosion-proof sensors 10 are arranged, they are preferably arranged, as shown in FIG. 8C, at every 120 degrees to the central axis of the waveguides 51 and 52. Accordingly, when multiple explosion-proof sensors 10 are arranged around the joint portion of the flanges, they are preferably arranged at a uniform angle to the central axis of the flanges.

Any number of the explosion-proof sensors 10 may be arranged around the joint portion 50 of the flanges 51a and 51b. For example, two explosion-proof sensors 10, or five or more explosion-proof sensors 10 may be arranged around the joint portion 50 of the flanges 51a and 51b. Note that it is beforehand unclear where in the joint portion 50 a microwave leakage occurs, and thus it is preferable to arrange the explosion-proof sensors 10 so that it is possible to detect microwaves leaking from an arbitrary position of the joint portion 50. Also, if the distance between the explosion-proof sensors 10 and the joint portion 50 is short, a larger number of explosion-proof sensors 10 may be arranged, and if the distance is long, a smaller number of explosion-proof sensors 10 may be arranged.

FIG. 9 is a diagram showing an example in which the explosion-proof sensors 10 are arranged in a hollow portion 56 provided at the joint portion 50 of the flanges 51a and 52a of the waveguides 51 and 52. Note that in FIG. 9, illustration of bolts and nuts used to fix the flanges 51a and 52a is omitted. Multiple (such as, for example, three or four) hollow portions 56 may be provided at a uniform angle to the central axis of the waveguides 51 and 52. In this case, one explosion-proof sensor 10 may be provided in each of the hollow portions 56. Although, in FIG. 9, illustrating is omitted, output wiring of the explosion-proof sensors 10 may extend to the outside of the waveguides 51 and 52 through wiring holes formed in the joint portion 50 or the flange 51a.

Also, the place at which a microwave leakage is desired to be detected may be, for example, a position at which a choke structure is provided, the choke structure being for preventing microwaves from leaking from inside to outside of a container in which microwave irradiation is performed. This is because, if the choke structure does not appropriately function, microwaves may leak from the position of the choke structure. In this case, one or more explosion-proof sensors 10 may be provided on the outer side of the choke structure for preventing microwaves from leaking from inside to outside of the container in which microwave irradiation is performed. The choke structure may be provided in a gap between the container in which microwave irradiation is performed and a stirring shaft extending from outside to inside of the container, or may be provided in a gap between the container in which microwave irradiation is performed and a door or a shutter of the container that is provided so as to be openable and closable.

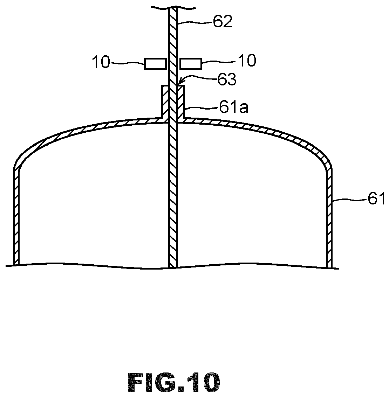

FIG. 10 is a cross-sectional view showing an example of a container 61 in which microwave irradiation is performed and a stirring shaft 62 extending from outside to inside of the container 61. In FIG. 10, it is assumed that a choke structure is provided in a gap 63 between a boss part 61a of the container 61 and the stirring shaft 62. Multiple explosion-proof sensors 10 are provided on the outer side of the choke structure.

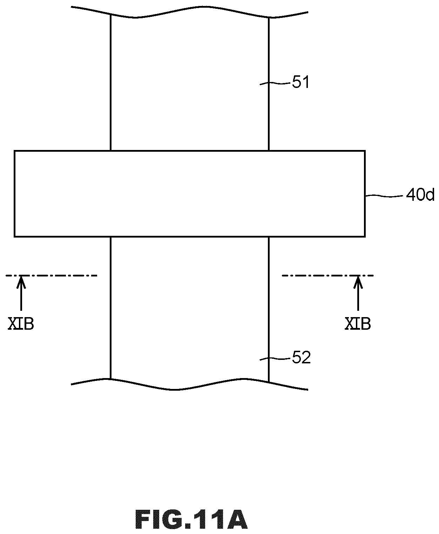

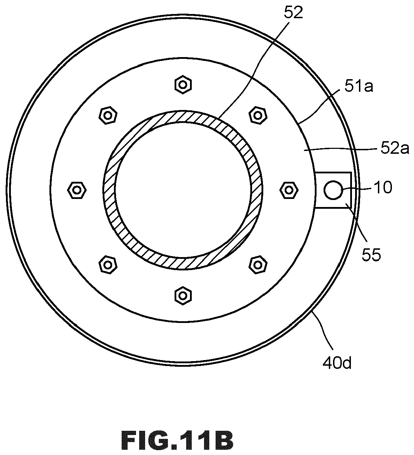

Note here that, although a case where multiple explosion-proof sensors 10 are disposed has been described, a single explosion-proof sensor 10 may be disposed. When a single explosion-proof sensor 10 is disposed, the reflective member 40 may also be used so as to enable appropriate detection of a microwave leakage from a joint portion of flanges, or the like. FIGS. 11A and 11B are diagrams showing a situation in which one explosion-proof sensor 10 and a tubular reflective member 40d are provided around the joint portion of the flanges 51a and 52a. FIG. 11A is a diagram showing the waveguides 51 and 52 when viewed in a direction perpendicular to the central axis of the waveguides 51 and 52, and FIG. 11B is a cross-sectional view taken along the line XIB-XIB in FIG. 11A. Note that in FIGS. 11A and 11B, illustration of attachments for attaching the reflective member 40d to the waveguides 51 and 52 is omitted. As shown in FIGS. 11A and 11B, the tubular reflective member 40d is arranged around the joint portion of the flanges 51a and 52a of the waveguides 51 and 52 such that the central axis of the reflective member 40d is coaxial with the central axis of the waveguides 51 and 52. Accordingly, microwaves leaking from a position in the joint portion of the flanges 51a and 52a are reflected on the inner circumferential surface of the tubular reflective member 40d or the outer circumferential surface of the waveguides 51 and 52, are guided to the single explosion-proof sensor 10, and are detected by the explosion-proof sensor 10. In this way, by appropriately arranging the reflective member 40, it is also possible to reduce the number of explosion-proof sensors 10.

Then, in the microwave leakage detecting step, a microwave leakage is detected in accordance with detection of an increase in at least one of an electric field and a magnetic field by at least one of the arranged one or more explosion-proof sensors 10. The step may also be executed while a microwave irradiation process is executed. That is to say, a microwave leakage may be detected when microwaves are introduced into the internal space of the hollow member, or microwave irradiation is performed within the container provided with a choke structure. The microwave leakage detection may also be executed by the detection unit 20, for example. Also, in the microwave leakage detecting step, upon detection of an increase in at least one of an electric field and a magnetic field by at least one of the explosion-proof sensors 10, it is also possible, for example, to output the fact that microwaves have leaked, or to execute processing for dealing with the microwave leakage, such as processing for disabling the microwave generator.

As described above, according to the microwave leakage detection device 1 and the microwave leakage detection method according to the present embodiment, the commercially-available explosion-proof sensor 10 capable of detecting at least one of an electric field and a magnetic field can be used to inexpensively detect microwave leakage within the explosion-proof area. Also, in response to the detection of a leakage of microwaves, irradiation of microwaves can be stopped, or an operator can be evacuated from the explosion-proof area, resulting in an enhancement in safety. For example, by arranging the explosion-proof sensor 10 at a joint portion of flanges, it is possible to detect a leakage of microwaves from this joint portion. Also, for example, by arranging the explosion-proof sensor 10 on the outer side of the choke structure, it is possible to detect a leakage of microwaves from the choke structure.

Also, in the sensor device 8 according to the present embodiment, the protective member 30 is provided in a sensing area of the explosion-proof sensor 10 to prevent the explosion-proof sensor 10 from sensing an object other than microwaves, thus making it possible to prevent false detection of an object other than microwaves. Also, when the sensor device 8 has the reflective member 40 for guiding microwaves to the explosion-proof sensor 10, it is possible to change the directional direction, realize microwave leakage detection using a smaller number of sensor devices 8, or enlarge the range in which microwave leakage can be detected by the single sensor device 8.

Note that although a case where the explosion-proof sensor 10 is an explosion-proof proximity sensor has been mainly described, the case is merely an option. The explosion-proof sensor 10 can be regarded as, other than the explosion-proof proximity sensor, a sensor with an explosion-proof structure capable of detecting an increase in at least one of an electric field and a magnetic field.

Also, the present invention may be modified in various ways without being limited to the above-described embodiment, and such various modifications are, of course, enclosed within the scope of the invention.

## Claims

1. A microwave leakage detection method comprising:
a step of arranging, in an explosion-proof area, one or more sensors with an explosion-proof structure capable of detecting an increase in at least one of an electric field and a magnetic field, at a joint portion of flanges of hollow members each having a space into which microwaves are introduced, or on the outer side of a choke structure for preventing microwaves from leaking from inside to outside of the hollow members; and
a step of detecting a microwave leakage in accordance with detection of an increase in at least one of an electric field and a magnetic field by at least one of the one or more sensors.

2. The microwave leakage detection method according to claim 1,
wherein each of the one or more sensors is an inductive or capacitive explosion-proof proximity sensor.

3. The microwave leakage detection method according to claim 1 or 2,
wherein the one or more sensors are directional.

4. The microwave leakage detection method according to any one of claims 1 to 3,
wherein, in the step of detecting a microwave leakage, a microwave leakage is detected when an output from at least one of the one or more explosion-proof sensors is equal to an output that corresponds to object detection.

5. A microwave leakage detection device comprising:
a sensor with an explosion-proof structure capable of detecting an increase in at least one of an electric field and a magnetic field; and
a detection unit configured to detect a microwave leakage in accordance with detection of an increase in at least one of an electric field and a magnetic field by the sensor,
wherein the sensor is arranged, in an explosion-proof area, at a joint portion of flanges of hollow members each having a space into which microwaves are introduced, or on the outer side of a choke structure for preventing microwaves from leaking from inside to outside of the hollow members.

6. The microwave leakage detection device according to claim 5,
wherein the sensor is an inductive or capacitive explosion-proof proximity sensor.

7. The microwave leakage detection device according to claim 5 or 6, further comprising:
a protective member that is provided so as to surround a detection range of the sensor, and through which microwaves are transmitted.

8. The microwave leakage detection device according to any one of claims 5 to 7, further comprising:
a reflective member provided around the sensor and configured to guide microwaves to the sensor.
